# EUROPEAN PATENT APPLICATION

(11) **EP 2 966 383 A1**
(43) Date of publication of application: **13.01.2016**
(21) Application number: 14461596.0
(22) Date of filing: 12.12.2014
(51) Int. Cl.: F25B 21/02, F25D 11/00, F25D 17/06, F25D 21/00, F25D 29/00, H01L 35/00

(54) **The method of reducing an energy consumption by thermoelectric refrigerator and a thermoelectric refrigerator**

(30) Priority: 07.07.2014 PL 40876814
(71) Applicant: Zachodniopomorski Uniwersytet Technologiczny w Szczecinie, 70-310 Szczecin (PL)
(72) Inventor: Filin, Sergiy, 71-541 Szczecin (PL); Jasi ska, Barbara, 71-612 Szczecin (PL); Zakrzewski, Bogus aw, 71-606 Szczecin (PL); Chmielowski, Micha, 71-075 Szczecin (PL)
(74) Representative: Zawadzka, Renata

(57) **Abstract**

The method of reducing an energy consumption by a thermoelectric refrigerator, according to the invention, equipped with a refrigeration chamber (1), refrigeration set (2) with an even number of thermoelectric modules (41, 42), heat exchangers (5, 7) and a fan (6) upon outer chamber's (1) side, temperature regulator (10) and electromagnetic relay (13), powered by DC grid, depending upon changing the configuration of thermoelectric modules (5, 7) from parallel to serial and back. However, the parallel module (5, 7) configuration is used in a moment of plugging the refrigerator in, as well as after crossing the inner chamber's (1) higher temperature threshold for regulator (10), while the serial module (5, 7) configuration is used after reaching the inner chamber's (1) lower temperature threshold for regulator (10). The method is characterized by, that during serial configuration, an inner chamber (1) fan (8) is supplied with the same voltage as the first thermoelectric module (41) synchronized with it, while during parallel configuration each fan, on an inner (8) and outer (9) side of a chamber (1) gets the same voltage as a corresponding thermoelectric module: the first (41) and the second (42) one, synchronized with it

The thermoelectric refrigerator, according to the invention, having the DC grid powered refrigeration set with an even thermoelectric module number (5, 7) and the same-grid powered fan (6) on an outer chamber's (1) side, serially connected temperature regulator (10) and an electromagnetic relay (13), is characterized by having on inner chamber's (1) fan (8) connected in parallel with the first thermoelectric module (41), while the fan (6) on an outer chamber (1) is plugged in with DC grid or in parallel with the second thermoelectric module (42).

## Description

The subject of the invention is a method of reducing the energy consumption by a thermoelectric refrigerator, and thermoelectric refrigerator itself. The invention refers to the realm of thermoelectric cooling, usually in means of conveyance that possess a DC current power grid, especially- working modes of a thermoelectric refrigerator supplied by a DC power source, photovoltaic panels included. It can be also applied in thermoelectric air conditioners and heating devices powered by aforementioned sources.

According to the edition of "Domowe i handlowe urz 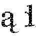 dzenia chlodnicze. Poradnik pod red. T. Fodemskiego" WNT, Warsaw, 2000, p. 221, there is a known way of two-positional temperature regulation (ON-OFF type) in refrigerators of different purpose, consisting of a manometrical temperature regulator (commonly called: a service thermostat), which is integrated into refrigerator's power source circuit. In case of compressor-based refrigerator, it is a power source circuit, while in absorption refrigerators- a heater's power circuit. After the refrigerator's chamber reaches the temperature of low thermostat setting (in a place of sensors installation), a compressor's cut-off occurs, while after reaching the high temperature setting, a thermostat starts a compressor again. The implementation of such temperature regulation method in thermoelectric refrigerators is possible, including the situation when a thermostat is integrated in a DC power circuit, alas presents low efficiency because of energy losses, as described in paper: Filin S., Owsicki A., Zakrzewski B.: Badania eksperymentalne ch 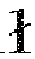 odziarek termoelektrycznych. Astroprint, Odessa, 2010. There is a known method of the temperature regulation, with the implementation of so-called "pause current", as described in paper: S.Filin, A.Owsicki: Rola pr 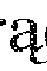 du zaporowego w dwupo 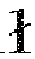 ożeniowej regulacji temperatury ch 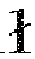 odziarek termoelektrycznych. Ch 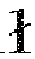 odnictwo, no. 3, 2001, p. 22. It is a two-level regulation method, where a temperature regulator switches the compressor power source from a higher voltage (working mode) to a lower one (energy-saving mode) and back. This regulation method is most often realized by switching a refrigeration set to another secondary winding of a voltage lowering transformer in AC power circuit. It is much more efficient when compared to ON-OFF, but it cannot be implemented while supplying a refrigerator from DC power grid. A proportional temperature regulation method is known, when supply voltage of a thermoelectric freezing set varies proportionally to temperature changes in a freezer's chamber (Filin S., Owsicki A.: Zasady projektowania i eksploatacji ch 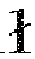 odziarek termoelektrycznych. ZAPOL, Szczecin, 2010, s. 92). Such regulation method requires a presence of complicated, expensive and unreliable electronic circuit, so it is seldom implemented in household and transport refrigerators. From paper: Filin S., Owsicki A., Zakrzewski B.: Badania eksperymentalne ch 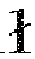 odziarek termoelektrycznych. Astroprint, Odessa, 2010., s. 65, a working mode of a transport thermoelectric refrigerator is known, for example, with 12V DC power circuit, containing a service thermostat connected to a power source in parallel with a refrigeration set, while being in series with electromagnetic relay at the same time. The working mode is realized in the following way: a thermostat-relay tandem switches a connection circuit of thermoelectric modules from parallel to serial, which results in a supply voltage drop from 12V down to 6V, power drain drops 4-times, while a supply voltage level of a fan remains unchanged. After the temperature increases in a refrigerator's chamber up to the level of higher thermostat threshold, a previous parallel connection is restored. In paper: Filin S., Owsicki A., Zakrzewski B.: Badania eksperymentalne ch 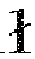 odziarek termoelektrycznych. Astroprint, Odessa, 2010., s. 65, a thermoelectric refrigerator is revealed, supplied from DC power grid and containing a thermally insulated chamber, a thermoelectric refrigeration set containing at least two thermoelectric modules as well as heat exchangers (radiators) on both module sides, a fan on a set's "hot" side, and a temperature regulator integrated into power supply circuit in parallel with an electromagnetic relay. Independently of a module supply mode, a fan is constantly supplied with it's nominal voltage, in this case-12V DC. In this refrigerator, a two-positional temperature regulation is realized, but it lacks a synchronization of a fan working mode with modules working mode.

A power consumption of fans is a significant factor in an energy-saving refrigerator power mode, because the share of fans in overall refrigerator's power consumption is substantial. Contemporary axial fans retain their working capability in a wide voltage span; from 5-6 V up to 15 V DC (Filin S., Owsicki A., Zakrzewski B.: Badania eksperymentalne ch 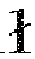 odziarek termoelektrycznych. Astroprint, Odessa, 2010). Thus, it is advisable to support, along with the energy-saving module working mode, an energy-saving fan working mode.

The invention's goal is a reduction of power input as well as an energy consumption of a thermoelectric refrigerator in two-positional regulation mode while being supplied from DC power grid.

The method of reducing an energy consumption by a thermoelectric refrigerator, according to the invention, having a refrigeration chamber, a thermoelectric set with an even number of thermoelectric modules, heat exchangers, a fan on the outer side of a chamber, a temperature regulator and an electromagnetic relay, and supplied from DC power grid, is realized by changing the configuration of thermoelectric modules, however the parallel configuration of modules is used during switching the refrigerator's power on, as well as after overpassing a higher temperature threshold in a refrigerator's chamber, while the serial connection is used after reaching a lower temperature threshold there. Invention is characterized by fact that during serial module configuration with supplying a fan in an inner chamber side with the same voltage as the first thermoelectric module synchronized (connected in parallel) with it, while during parallel module configuration each fan (on an inner and outer side of the chamber) is supplied with the same voltage as corresponding synchronized thermoelectric modules (the first and the second one). In another working variant of a refrigerator, during serial supplying, an outer chamber side fan is connected to the same voltage as the second thermoelectric module synchronized with it.

The thermoelectric refrigerator, according to the invention, having a DC grid powered refrigeration set with an even number of thermoelectric modules and a fan on an outer chamber side, powered from the same grid, a serially connected temperature regulator and an electromagnetic relay characterized by having an inner chamber side fan, connected in parallel with the first thermoelectric module. At the same time, an outer chamber side fan is connected to the grid (power source), or in parallel with the second thermoelectric module.

Favorably, the thermoelectric refrigerator has a fan on an inner refrigeration chamber side, connected in parallel with the first thermoelectric module, while both modules are connected from one side to the plus terminal of a grid and a work terminal of an electromagnetic relay from the other. This second work terminal has two positions- the first one and the second one. The first position of an electromagnetic relay's second work terminal is the one with negative fan terminal on an outer refrigeration chamber side and a negative terminal of the second thermoelectric module. The electromagnetic relay's second work terminal's second position is a connection of the second thermoelectric module's positive terminal and further, through the first contact of a relay- to a positive grid terminal. During parallel supply of a refrigerator, the second work terminal is in the first position and the first terminal remains closed, while during serial (energy-saving) supply mode, the second work terminal is in the second position and the first one remains open. An outer chamber side fan is connected to the grid, or connected in parallel with the second thermoelectric module.

In case of more than two, even number of thermoelectric modules, a fan is connected in parallel to a group of modules. For example, a 12 V fan - to twin serially connected 6 V modules, while 24V fan - to twin serially connected 12 V modules or four 6 V ones etc.

It is not recommended to connect both fans (on an outer and inner chamber side) in parallel with a single thermoelectric module, because it results in greater differentiation of currents, flowing through thermoelectric modules, which in turn leads to irregularities of temperature fields on heat exchangers, thus- to unnecessary losses. The advantage of proposed solution in accordance with the innovation, compared to the solution with ON-OFF working mode, is a fact that a power input of a refrigerator working in energy-saving mode is 3-4 times lower, and corresponding- daily energy consumption is 2-3 time lower. The actual saving values depend on thermostat settings level and frequency of refrigerator's use.

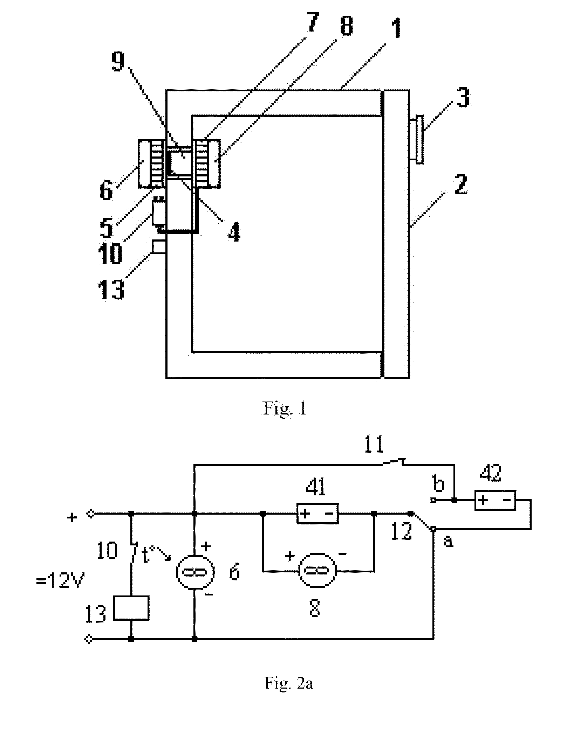

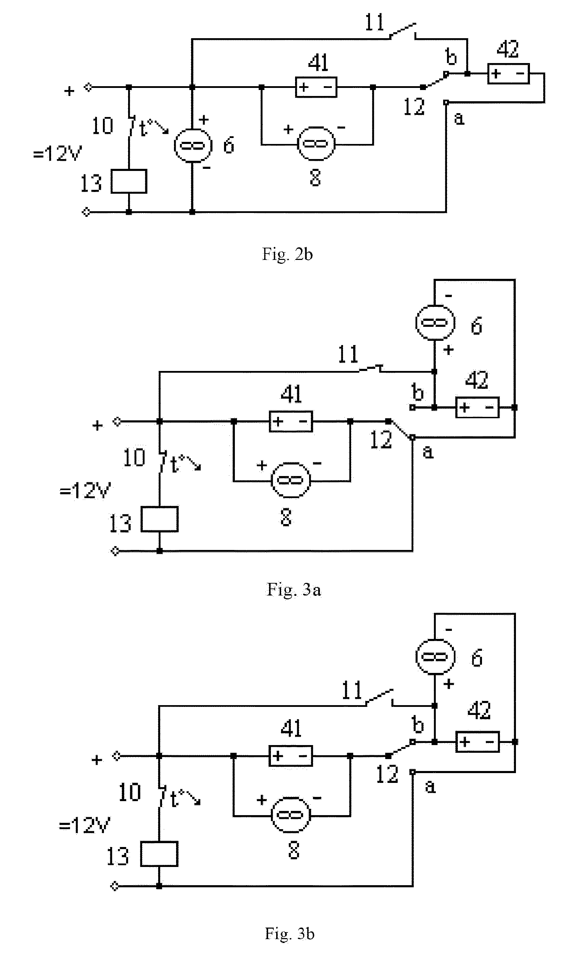

The invention's subject is revealed in examples and on figures, where fig. 1 shows a thermoelectric refrigerator in longitudinal intersection, fig. 2 shows a sketch of electrical circuit of a refrigerator in energy-saving mode, fig. 3a shows a sketch of electrical circuit of a refrigerator with twin fans synchronized with modules in working mode, while fig. 3b shows a sketch of electrical circuit of a refrigerator with twin fans synchronized with modules in energy-saving mode. The table reveals values for thermoelectric modules and fans voltage in energy-saving and working mode for two variants of fan-module connection.

### Example 1

A thermoelectric refrigerator is plugged to DC power grid- onboard 12V DC vehicle grid and contains: thermally insulated chamber 1, door 2 with a handle 3, refrigeration set consisting of twin thermoelectric modules, the first 41 and the second 42, common for both modules heat exchanger 5 on an outer chamber side (hot radiator with a fan 6), common for both modules heat exchanger 7 on an inner chamber side (cold radiator with a fan 8). Each thermoelectric module 41 and 42 is heat-linked with heat exchanger 7 through heat conducting element 9. The refrigerator is equipped with a temperature regulator 10 as well as an electromagnetic relay 13. A temperature regulator's sensor 10 is installed in refrigeration chamber 1 and remains heat-linked with heat exchanger 7. An outer fan 6 is plugged into 12 V DC grid independently from thermoelectric module 41 and 42 configuration. However, an inner chamber fan 8 is plugged into DC grid in parallel with the first thermoelectric module 41.

The method of energy reduction is based upon following operations. After plugging the refrigerator into DC power grid (12 V DC), it stays in a work mode, which means- with full refrigeration output. Thermoelectric modules 41, 42 are plugged to a grid through terminals: first 11 and second 12 of an electromagnetic relay 13. The relay 13 has three pairs of work terminals, which allows to switch the configuration of thermoelectric modules 41 and 42 from serial to parallel and back. In work mode, a voltage is supplied to relay 13 through connected terminals of temperature regulator 10, however sockets 11 and 12 of a relay 13 have position (as on fig, 2a): 11 - closed and 12- in position a, which allows for parallel supply of thermoelectric modules 41 and 42, both fans 8 and 6 with a current from 12 V DC power source.

The temperature in cooling chamber decreases and by the moment it reaches the lower threshold of a regulator 10, this one cuts off voltage of the relay 13, which results in change of position for terminals 11 (open) and 12 (in position b) of relay 13 and thus, switching the arrangement of thermoelectric modules 41 and 42 from parallel to serial. This is the energy-saving mode of a refrigerator, where the voltage on each thermoelectric module 41 and 42 reaches around 6V, a power consumption drops 4 times and cooling output- less than 2 times adequately. A heat exchanger's 5 heat load drops along. This fact comes with a possibility of lowering an outer fan's 6 output without the significant deterioration of heat exchange conditions on heat exchanger 5. Switching the fan 8 into energy-saving mode is realized through it's parallel connection to the first thermoelectric module 41.

After the set has entered into energy-saving mode, the chamber temperature may increase slightly (1-3°C average). If an increase of a refrigerators heat load doesn't happen, the energy saving mode can stay indefinitely. To switch the set again (temporarily) to work mode, the chamber temperature shall increase up to regulator's 10 higher threshold, which happens in case of putting warm products into the chamber, longer door opening times, or a significant ambience temperature increase.

### Example II

The refrigerator made analogically as in Example I, except that the outer fan 6 is plugged in parallel with the second thermoelectric module 42 into a power source. After the refrigerator is switched into an energy-saving mode, the fan 6 is supplied with half the voltage, thus 6V, as the fan 8. In following mode, the heat load of exchanger 5 decreases. It comes with the possibility of decreasing the outer fan's 6 output without the significant decrease of heat exchange conditions on exchanger 5.

**Table**

| work mode | configuration of modules 41 and 42 and voltage values on each one | outer fan 6 voltage | inner fan 8 voltage | number of fig. |
|---|---|---|---|---|
| work | parallel (12 V) | 12 V | 12 V | fig. 2a |
| | | 12 V | 12 V | fig. 3a |
| energy saving | serial (6 V) | 12 V | 6 V | fig. 2b |
| | | 6 V | 6 V | fig. 3b |

## Claims

1. The method of reducing an energy consumption by a thermoelectric refrigerator, having a refrigeration chamber, a thermoelectric refrigeration set with an even number of thermoelectric modules, heat exchangers, fan on outer side of said chamber, a temperature regulator and an electromagnetic relay, connected to a DC power grid, which method is realized by changing the configuration of thermoelectric modules from serial to parallel and vice versa, where the parallel supply of thermoelectric modules is used for starting the refrigerator's operation as well as when the inner chamber's temperature exceeds the higher regulator's threshold, while the serial thermoelectric module supply is used after reaching the lower temperature regulator's threshold, is **characterized by**, that during the serial configuration, the fan (8) on the inner chamber's (1) side is supplied with the same voltage as the first thermoelectric module (41) synchronized with it, while during the parallel configuration each fan on the inner (8) and outer (6) chamber's (1) side is supplied with the same voltage as an adequately first (41) and the second (42) thermoelectric module synchronized with it.

2. The method of reducing an energy according to claim claim 1, is **characterized by**, that during the serial configuration, the fan (6) on the outer chamber's (1) side is supplied with the same voltage as the second thermoelectric module (42) synchronized with it.

3. A thermoelectric refrigerator, having a DC grid powered thermoelectric refrigeration set with an even number of thermoelectric modules, the same-grid powered fan on the outer chamber's side, a serially connected temperature regulator and an electromagnetic relay, is **characterized by** having the fan (8) on the inner chamber's (1) side connected to the first thermoelectric module (41) parallel, and the fan (6) is connected to a DC grid or in parallel with the second thermoelectric module (42).

4. A refrigerator according to claim 3, is **characterized by** having a fan (8) on the inner chamber's (1) side, connected in parallel to the first thermoelectric module (41), while both are connected from one side to the positive grid terminal and from the other- to the second work terminal (12) of an electromagnetic relay (13), of which the second terminal (12) has two positions the first (a) where the negative terminal of outer chamber's fan (6) is connected along with the negative socket of second thermoelectric module (42), and the second position (b), where connection is made with the positive terminal of a second thermoelectric module (42) and through the first work terminal (11) of an electromagnetic relay (13), with the positive grid terminal, while the outer fan (6) is connected to a grid directly, or in parallel with the second thermoelectric module (42).
